Europäisches Patentamt

European Patent Office

Office européen des brevets

(19)

(11) **EP 0 533 549 B1**

(12) **FASCICULE DE BREVET EUROPEEN**

(45) Date de publication et mention
de la délivrance du brevet:
**12.11.1997 Bulletin 1997/46**

(51) Int Cl.6: **H04L 25/12**, H04B 3/00

(21) Numéro de dépôt: **92402517.4**

(22) Date de dépôt: **15.09.1992**

(54) **Dispositif d'adaptation d'impédance pour liaisons par lignes de transmission entre un ou plusieurs émetteurs et un ou plusieurs récepteurs de signaux**

Einrichtung zur Impedanzanpassung für Verbindungen über Übertragungsleitungen zwischen ein oder mehreren Sendern und ein oder mehreren Empfängern von Signalen

Impedance matching device for transmission lines between one or more transmitters and one or more receivers of signals

(84) Etats contractants désignés:
**AT BE CH DE ES FR GB IT LI NL SE**

(30) Priorité: **16.09.1991 FR 9111367**

(43) Date de publication de la demande:
**24.03.1993 Bulletin 1993/12**

(73) Titulaire: **ALCATEL ALSTHOM COMPAGNIE GENERALE D'ELECTRICITE**
**75008 Paris (FR)**

(72) Inventeurs:
• **Hautecloque, Françis**
  **F-22300 Lannion (FR)**
• **Geffroy, Pascal**
  **F-22300 Lannion (FR)**

(74) Mandataire: **Sciaux, Edmond et al**
**ALCATEL ALSTHOM,**
**Département de Propriété Industrielle,**
**30, avenue Kléber**
**75116 Paris (FR)**

(56) Documents cités:
**EP-A- 0 410 402**

• **EDN ELECTRICAL DESIGN NEWS. vol. 35, no. 7, 29 Mars 1990, NEWTON, MASSACHUSETTS US pages 145 - 151 J.K.MURASHIGE 'MINIMIZE PARASITIC PROBLEMS IN HIGH-SPEED DIGITAL SYSTEMS'**

## Description

La présente invention concerne un dispositif d'adaptation d'impédance pour liaisons unidirectionnelles, par lignes de transmission, entre un ou plusieurs émetteurs de signaux électriques et un ou plusieurs récepteurs. Elle s'applique de façon particulièrement avantageuse, aux circuits utilisant les technologies TTL et CMOS, mais est aussi applicable aux autres technologies telles que NMOS, ECL, etc.

Les liaisons visées doivent permettre des échanges de données, sous forme logique, à des débits élevés et, par exemple, la distribution de signaux d'horloge à fréquence élevée, à partir de circuits intégrés des familles TTL ou CMOS. Les lignes de transmission utilisées dans ces liaisons peuvent, par exemple, être réalisées sur des cartes électroniques sous forme de pistes de circuit imprimé, mais également sur d'autres supports appropriés. Une adaptation d'impédance entre les émetteurs de signaux et les lignes de transmission doit permettre de préserver l'intégrité des signaux transmis.

Le document EDN ELECTRICAL DESIGN NEWS, vol.35, n°7, 29 mars 1990, NEWTON, MASSACHUSSETTS US, pages 145-151, J.K.MURASHIGE "MINIMIZE PARASITIC PROBLEMS IN HIGH SPEED DIGITAL SYSTEMS" décrit plusieurs dispositifs d'adaptation d'impédance pour une liaison entre la sortie d'un émetteur de signaux et l'entrée d'un récepteur de signaux, ou d'un groupe de récepteurs de signaux. En particulier, il décrit un dispositif comportant une résistance $R_s$ en série avec une ligne ayant une impédance caractéristique $Z_0$ , pour relier la sortie d'un émetteur de signaux ayant une impédance de sortie $Z_s$ et l'entrée d'un groupe de récepteurs de signaux ayant une impédance d'entrée $Z_{is}$ . Les valeurs de $R_s$ et $Z_0$ sont choisies de façon que :

$$Z_s = R_s + Z_{is}$$

Il y a ainsi adaptation entre la sortie de l'émetteur et sa charge. Les signaux réfléchis par l'entrée du récepteur ne sont pas réfléchis une seconde fois par la sortie de l'émetteur. Ce dispositif connu ne convient pas cependant lorsque les récepteurs ne sont pas regroupés en un seul groupe dont les dimensions sont négligeables par rapport à la distance parcourue par un signal électrique pendant la durée d'un bit. Les liaisons respectives entre l'extrémité d'une telle ligne et les entrées des récepteurs présentent alors des impédances respectives qui ne sont adaptées ni à la ligne ni aux entrées des récepteurs. Elles sont donc la cause de réflexions de signaux vers les récepteurs. Ces réflexions perturbent les signaux de manière non négligeable.

Ce dispositif connu ne convient pas non plus dans le cas où les émetteurs ne sont pas regroupés en un seul groupe dont les dimensions sont négligeables par rapport à la distance parcourue par un signal électrique pendant la durée d'un bit. Les liaisons respectives entre les sorties des émetteurs et une telle résistance $R_s$ présentent alors des impédances respectives qui ne sont adaptées ni à la résistance $R_s$ ni aux impédances de sortie des émetteurs. Elles sont donc la cause de réflexions qui perturbent les signaux de manière non négligeable.

La présente invention vise notamment à permettre la réalisation d'adaptations d'impédances optimales, d'une part dans des liaisons entre un émetteur ou un groupe d'émetteurs ayant une sortie commune, et deux ou plusieurs récepteurs (liaison point vers multipoints) et, d'autre part, dans des liaisons entre deux émetteurs ou deux groupes d'émetteurs, et un récepteur ou un groupe de récepteurs à entrée commune (liaison multipoints vers point).

L'objet de l'invention est un dispositif d'adaptation d'impédance pour liaisons unidirectionnelles par lignes de transmission entre un ou plusieurs émetteurs de signaux électriques et deux ou plusieurs récepteurs ; caractérisé en ce que la sortie d'un émetteur, ou d'un groupe d'émetteurs ayant une sortie commune, est reliée aux entrées de $\underline{n}$ différents récepteurs , ou de $\underline{n}$ groupes de récepteurs , les récepteurs de chaque groupe ayant une entrée commune , respectivement par l'intermédiaire de lignes de transmission ayant une même impédance caractéristique $Z_c$ et une même longueur identique, ces lignes de transmission ayant un point de connexion de départ commun, connecté directement à ladite sortie ;

et en ce qu'il comporte en outre $\underline{k}$ lignes supplémentaires non connectées à des récepteurs, mais étant connectés au dit point commun, ces lignes ayant la même impédance caractéristique $Z_c$ et la même longueur que lesdites $\underline{n}$ lignes de transmission, le nombre $\underline{k}$ de ces lignes supplémentaires étant choisi de façon que $Z_s$ soit au moins approximativement égal à $Z_c$ / (n+k) , où Zs est l'impédance de sortie de l'émetteur ou du groupe d'émetteurs.

L'invention permet ainsi de réaliser des liaisons qui sont économiques, exigent une faible puissance de sortie des émetteurs et ont une faible consommation d'énergie, tout en procurant, dans les différentes configurations visées, une adaptation efficace éliminant des différences de temps de propagation des signaux entre émetteurs et récepteurs et évitant des dégradations des signaux transmis. Elle fournit, en outre, une solution compatible avec une densité d'implantation élevée sur des cartes logiques, puisque le dispositif proposé ne comporte pas plus qu'une seule impédance d'adaptation par sortie d'émetteur.

L'invention sera mieux comprise à la lumière des formes de réalisation décrites ci-après à titre d'exemples et illustrées par le dessin annexé, dans lequel

la Fig. 1 est un schéma d'un dispositif d'adaptation d'impédance selon l'invention dans le cas d'une liaison point vers multipoints, et

la Fig. 2 est un schéma d'un dispositif selon l'invention dans le cas d'une liaison multipoints vers point, qui cependant ne fait pas partie de la présente invention.

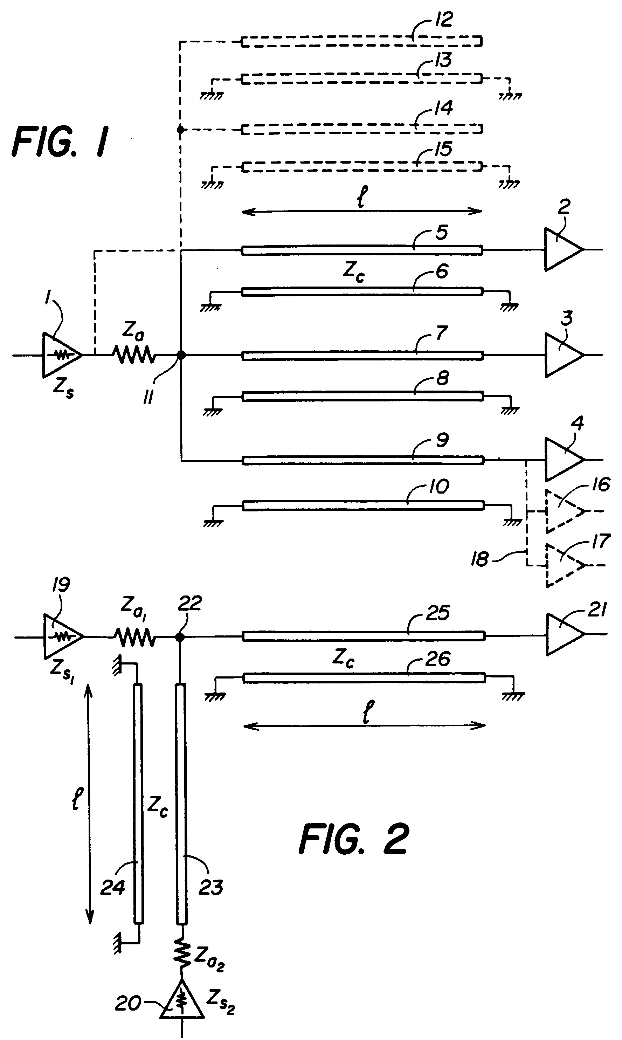

Dans le dispositif selon la Fig. 1, un émetteur 1 de signaux à débit élevé, par exemple de l'ordre de 50 Mbit/sec, ayant une impédance de sortie $Z_s$, fournit ces signaux à trois récepteurs 2,3,4 par l'intermédiaire de trois lignes de transmission constituées respectivement par des pistes de circuits imprimés 5 et 6, 7 et 8, 9 et 10. Les longueurs de ces lignes sont identiques, soit égales à l, et leurs impédances caractéristiques $Z_c$ sont égales entre elles. Le point de départ de ces lignes est un point de connexion commun 11 et une impédance d'adaptation $Z_a$ est montée entre ce point de connexion et la sortie de l'émetteur 1. Si la valeur de l'impédance de sortie de cet émetteur est, par exemple, $Z_s = 15$ ohms et l'impédance des lignes $Z_c = 77$ ohms, on choisira une impédance d'adaptation $Z_a = 10$ ohms pour satisfaire la condition d'adaptation $Z_s + Z_a$ environ égal à $Z_c/n$, avec n = 3, puisque $Z_s + Z_a = 25$ ohms et $Z_c/3 = 25,7$ ohms. La longueur des lignes 5 à 10 peut être quelconque, à condition qu'elle soit identique pour toutes les lignes, celles-ci ayant toutes la même vitesse de propagation des signaux. Les ondes réfléchies vers la sortie de l'émetteur 1 sont donc en phase sur toutes les lignes 5 à 10, ce qui permet d'utiliser une impédance d'adaptation $Z_a$ unique. Ceci constitue un avantage important, étant donné la densité de composants souvent très élevée sur les cartes logiques. Bien entendu, il est possible que l'impédance $Z_a$ ne soit pas nécessaire si la condition d'adaptation est réalisée avec $Z_a = 0$. Il est également à noter que ce dispositif est facilement intégrable à une conception assistée par ordinateur.

La Fig. 1 montre, en lignes pointillées, le mode d'exécution du dispositif d'adaptation selon l'invention, qui peut être particulièrement avantageux dans certaines configurations. Selon l'invention, l'impédance $Z_a$ est supprimée et, en revanche, deux lignes supplémentaires sont rajoutées sur le circuit. Ces lignes, représentées respectivement par des pistes 12, 13 et 14 ,15 ont la même impédance caractéristique et la même longueur que chacune des lignes de transmission aux récepteurs 2, 3 et 4, mais elles ne sont pas connectées à des récepteurs. Dans l'exemple numérique indiqué, on obtient $Z_c/5 = 15,4$ ohms, ce qui satisfait de nouveau, avec une approximation suffisante, la condition d'adaptation.

En outre, la Fig. 1 illustre, également en lignes pointillées, la présence éventuelle, dans le cadre d'un dispositif selon l'invention, d'un groupe de récepteurs 4, 16, 17 ayant une entrée commune 18, de tels groupes pouvant être utilisés soit au niveau des émetteurs, soit au niveau des récepteurs. On entend par groupe un ensemble d'émetteurs ou de récepteurs tellement proches que les différences des temps de propagation respectifs sont négligeables.

La Fig. 2 montre un dispositif d'adaptation, ne faisant cependant pas partie de l'invention, dans le cas d'une liaison multipoints vers point, pour le cas où le nombre d'émetteurs ne dépasse pas deux émetteurs ou deux groupes d'émetteurs. Dans l'exemple représenté, deux émetteurs 19, 20 sont couplés à un récepteur 21. Ce dispositif comprend des premières parties de liaison entre les émetteurs et un point de connexion commun 22, ces parties étant constituées, pour l'émetteur 19, par une impédance $Z_{a1}$ et pour l'émetteur 20 par le montage en série d'une impédance d'adaptation $Z_{a2}$ et d'une ligne de transmission ayant une longueur l et une impédance caractéristique $Z_c$, constituée par des pistes de circuits imprimés 23, 24. Une seconde partie de liaison, commune, relie le point 22 à l'entrée du récepteur 21 et est constituée par une ligne de transmission 25, 26 de même longueur et de même impédance caractéristique que la ligne 23, 24.

Dans ce cas, la condition d'adaptation est réalisée si l'on choisit $Z_{a1}$ de façon que $Z_{s1} + Z_{a1}$ soit environ égal à $Z_c/2$, et $Z_{a2}$ de façon que $Z_{s2} + Z_{a2}$ soit environ égal à $Z_c$.

Cette solution présente également les qualités déjà mentionnées au début, notamment du point de vue son efficacité, du nombre réduit de composants nécessaires et de la consommation réduite. Elle ne convient que pour deux émetteurs ou deux groupes d'émetteurs. Toutefois, un grand nombre de cas d'applications pratiques peuvent être résolus par le dispositif selon le schéma de la Fig. 2. Bien entendu, les remarques précédentes concernant l'éventuelle suppression d'une impédance d'adaptation et l'utilisation de groupes de récepteurs, restent également valables pour le cas d'une telle liaison multipoints vers point.

## Revendications

1. Dispositif d'adaptation d'impédance pour liaisons unidirectionnelles par lignes de transmission entre un ou plusieurs émetteurs (1) de signaux électriques et deux ou plusieurs récepteurs (2, 3, 4, 16, 17),

   caractérisé en ce que la sortie d'un émetteur, ou d'un groupe d'émetteurs ayant une sortie commune, est reliée aux entrées de n différents récepteurs (2, 3, 4), ou de n groupes de récepteurs (4, 16,17), les récepteurs de chaque groupe ayant une entrée commune (18), respectivement par l'intermédiaire de lignes de transmission (5, 6; 7, 8; 9,10) ayant une même impédance caractéristique $Z_c$ et une même longueur identique, ces lignes de transmission ayant un point de connexion de départ commun (11), connecté directement à ladite sortie ;

   et en ce qu'il comporte en outre k lignes supplémentaires (12,13; 14,15) non connectées à des récepteurs, mais étant connectés au dit point commun (11), ces lignes ayant la même impédance caractéristique $Z_c$ et la même longueur que lesdites n lignes de transmission, le nombre k de ces lignes supplémentaires étant choisi de façon que $Z_s$ soit au moins approximativement égal à $Z_c$ / (n+k), où Zs est l'impédance de sortie de l'émetteur ou du groupe d'émetteurs (1).

**Patentansprüche**

1. Impedanzanpassungsvorrichtung für in einer Richtung wirksame Verbindungen über Übertragungsleitungen zwischen einem oder mehreren Sendern (1) für elektrische Signale und zwei oder mehreren Empfängern (2, 3, 4, 16, 17),
dadurch gekennzeichnet, daß der Ausgang eines Senders oder einer Gruppe von Sendern mit einem gemeinsamen Ausgang an die Eingänge von n unterschiedlichen Empfängern (2, 3, 4) oder von n Gruppen von Empfängern (4, 16, 17) mit einem gemeinsamen Eingang (18) über je eine Übertragungsleitung (5, 6; 7, 8; 9, 10) angeschlossen sind, die eine gleiche charakteristische Impedanz ($Z_c$) und eine gleiche Länge besitzen und einen gemeinsamen an den erwähnten Ausgang direkt angeschlossenen Verbindungspunkt (11) besitzen, und daß die Vorrichtung außerdem k zusätzliche, nicht an Empfänger angeschlossene Leitungen (12, 13; 14, 15) aufweist, die an den gemeinsamen Punkt (11) angeschlossen sind und alle die gleiche charakteristische Impedanz ($Z_c$) und die gleiche Länge wie die n Übertragungsleitungen besitzen, wobei die Zahl k dieser zusätzlichen Leitungen so gewählt wird, daß $Z_s$ mindestens angenähert gleich $Z_c$/(n+k) ist, wobei $Z_s$ die Ausgangsimpedanz des Senders oder der Gruppe von Sendern (1) ist.

**Claims**

1. Impedance-matching apparatus for one-way links via transmission lines between one or more transmitters (1) for transmitting electrical signals and two or more receivers (2, 3, 4, 16, 17);
said apparatus being characterized in that the output of a transmitter, or of a group of transmitters having a common output, is connected to the inputs of n different receivers (2, 3, 4) or of n groups of receivers (4, 16, 17), the receivers in each group having a common input (18), via respective transmission lines (5 & 6, 7 & 8, and 9 & 10) having the same characteristic impedance $Z_c$ and the same length, the transmission lines having a common starting connection point (11) connected directly to said output;
and in that the apparatus further includes k additional lines (12 & 13, and 14 & 15) not connected to receivers, but being connected to said common point (11), which lines have the same characteristic impedance $Z_c$ and the same length as said n transmission lines, the number k of the additional lines being chosen such that $Z_s$ is at least approximately equal to $Z_c$/(n+k), where $Z_s$ is Lhe output impedance of the transmitter or of the group of transmitters (1).

FIG. 1

FIG. 2